# EUROPEAN PATENT APPLICATION

(11) **EP 2 503 598 A2**
(43) Date of publication of application: **26.09.2012**
(21) Application number: 10831747.0
(22) Date of filing: 01.11.2010
(51) Int. Cl.: H01L 31/042

(54) **SOLAR PHOTOVOLTAIC DEVICE**

(30) Priority: 18.11.2009 KR 20090111719; 18.11.2009 KR 20090111718
(71) Applicant: LG Innotek Co., Ltd., Seoul 100-714 (KR)
(72) Inventor: CHO, Ho Gun, Seoul 100-714 (KR)
(74) Representative: Novagraaf Technologies
(86) International application number: PCT/KR2010/007617
(87) International publication number: WO 2011/062380

(57) **Abstract**

Disclosed is a solar cell apparatus. The solar cell apparatus includes a support substrate, a solar cell on a top surface of the support substrate, and a circuit board connected to the solar cell and provided on both the top surface of the support substrate and a lateral side of the support substrate.

## Description

### [Technical Field]

The embodiment relates to a solar cell apparatus.

### [Background Art]

A solar cell module for converting photo energy into electric energy through the photoelectric transformation effect has been extensively used to obtain clean energy contributing to environmental conservation of the earth.

As the photoelectric transformation efficiency of a solar cell has been improved, a solar cell system including the solar cell module is used for the residential purpose.

In order to output power generated from the solar cell module including solar cells that generate power from the solar light, conductors having the function of positive and negative electrodes are provided in the solar cell module, and terminals of the conductors, which serve as connectors connected to a cable to output current to the outside, are provided out of a photovoltaic module.

### [Disclosure]

### [Technical Problem]

The embodiment provides a solar cell apparatus which can be readily manufactured and prevent short.

### [Technical Solution]

According to one embodiment, there is provided a solar cell apparatus including a support substrate, a solar cell on a top surface of the support substrate, and a circuit board connected to the solar cell and provided on both the top surface of the support substrate and a lateral side of the support substrate.

According to another embodiment, there is provided a solar cell apparatus including a support substrate, a first solar cell on the support substrate, a second solar cell spaced apart from the first solar cell, a plurality of third solar cells between the first and second solar cells, a first circuit board connected to the first solar cell and extending on a first lateral side of the support substrate, and a second circuit board connected to the second solar cell and extending on a second lateral side of the support substrate.

According to still another embodiment, there is provided a solar cell apparatus including a support substrate, a first solar cell on the support substrate, a second solar cell on the support substrate, and a circuit board connected to the first and second solar cells. The circuit board includes a first connection part connected to a top surface of the first solar cell, a second connection part connected to a top surface of the second solar cell, and an extension part formed integrally with the first and second connection parts and extending along a lateral side of the support substrate.

### [Advantageous Effects]

As described above, according to the solar cell apparatus of the embodiment, electrical energy generated from the solar cell can be output through the circuit board. In particular, the circuit board outputs the electrical energy through the lateral side of the support substrate.

Accordingly, according to the solar cell apparatus of the embodiment, a hole, which is used to connect the cable of outputting electrical energy to the outside with the solar cell, may not be provided in the support substrate.

In addition, the circuit board maybe readily attached to the support substrate through the adhesive layer.

Therefore, the solar cell apparatus according to the embodiment can be readily manufactured.

In addition, since the hole is not formed in the support substrate, the solar cell apparatus according to the embodiment may have more improved strength.

According to the solar cell apparatus according to the embodiment, since solar cells are connected to a solar cell module through the circuit board, the short caused by connection failure can be prevented.

According to the solar cell apparatus of the embodiment, electrical energy generated from the solar cell can be output through the circuit board. In particular, the circuit board outputs the electrical energy through the lateral side of the support substrate.

Accordingly, according to the solar cell apparatus of the embodiment, a hole, which is used to connect the cable of outputting electrical energy to the outside with the solar cell, may not be provided in the support substrate.

In addition, the circuit board may be readily attached to the support substrate through the adhesive layer.

In addition, according to the solar cell apparatus of the embodiment, the circuit board can be directly connected to the solar cell. Therefore, the solar cell apparatus according to the embodiment may not employ the connection member such as the bus bar.

Therefore, the solar cell apparatus according to the embodiment can be readily manufactured.

In addition, since the hole is not formed in the support substrate, the solar cell apparatus according to the embodiment may have more improved strength.

According to the solar cell apparatus of the embodiment, the circuit board can be directly connected to the solar cell, and the solar cell can be connected to the solar cell module through the circuit board. Therefore, according to the solar cell apparatus of the embodiment, the short caused by connection failure can be prevented.

Since the solar cell panels are connected to each other by using the circuit board, the incidence area of the solar light can be increased. In other words, the flexible printed circuit board can be more freely attached to the solar cell panel as compared with the bus bar. Therefore, the exposed are of the solar cell panel can be maximized.

### [Description of Drawings]

FIG. 1 is an exploded perspective view showing a solar cell module according to a first embodiment;

FIG. 2 is a plan view the connection state of a solar cell panel, a bus bar, and a flexible printed circuit board;

FIG. 3 is a bottom view showing the connection state of a flexible printed circuit board and a junction box;

FIG. 4 is a sectional view taken along line A-A' of FIG. 2;

FIG. 5 is a perspective view showing the flexible printed circuit board;

FIG. 6 is a sectional view taken along line B-B' of FIG. 5;

FIG. 7 is an exploded perspective view showing a solar cell module according to a second embodiment;

FIG. 8 is a plan view showing the connection state between the flexible printed circuit board and the solar cell panel;

FIG. 9 is a bottom view showing the connection state between the flexible printed circuit board and the solar cell panel;

FIG. 10 is a sectional view taken along line C-C' of FIG. 8;

FIG. 11 is a plan view showing the flexible printed circuit board;

FIG. 12 is a plan view showing the connection between a solar cell panel and a flexible printed circuit board in the solar cell module according to a third embodiment;

FIG. 13 is a sectional view taken along line D-D' of FIG. 12; and

FIG. 14 is a plan view showing the flexible printed circuit board.

### [Best Mode]

### [Mode for Invention]

In the description of the embodiments, it will be understood that, when a layer (or film), a region, a pattern, or a structure is referred to as being "on" or "under" another substrate, another layer (or film), another region, another pad, or another pattern, it can be "directly" or "indirectly" on the other substrate, layer (or film), region, pad, or pattern, or one or more intervening layers may also be present. Such a position of the layer has been described with reference to the drawings. The thickness and size of each layer shown in the drawings may be exaggerated, omitted or schematically drawn for the purpose of convenience or clarity. In addition, the size of elements does not utterly reflect an actual size.

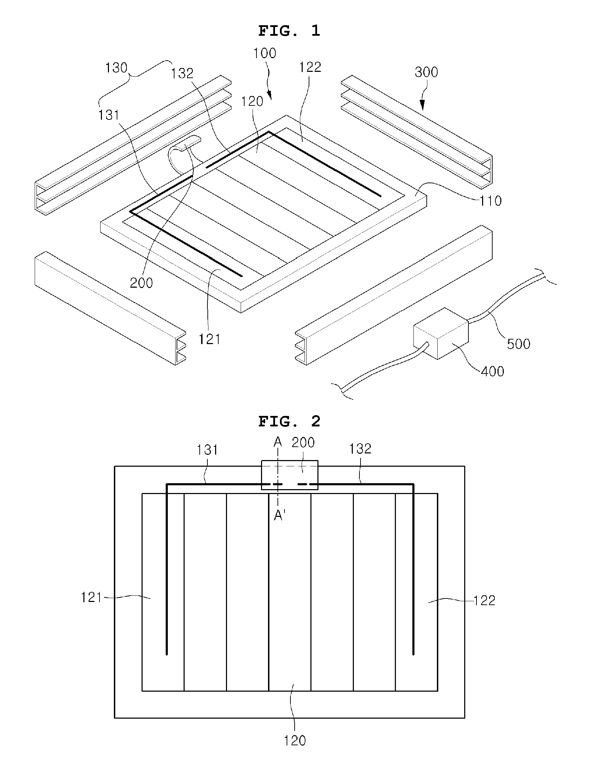

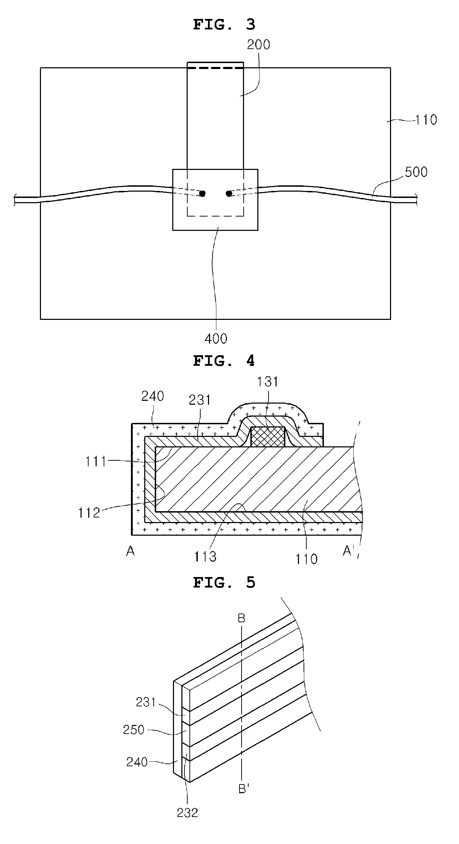

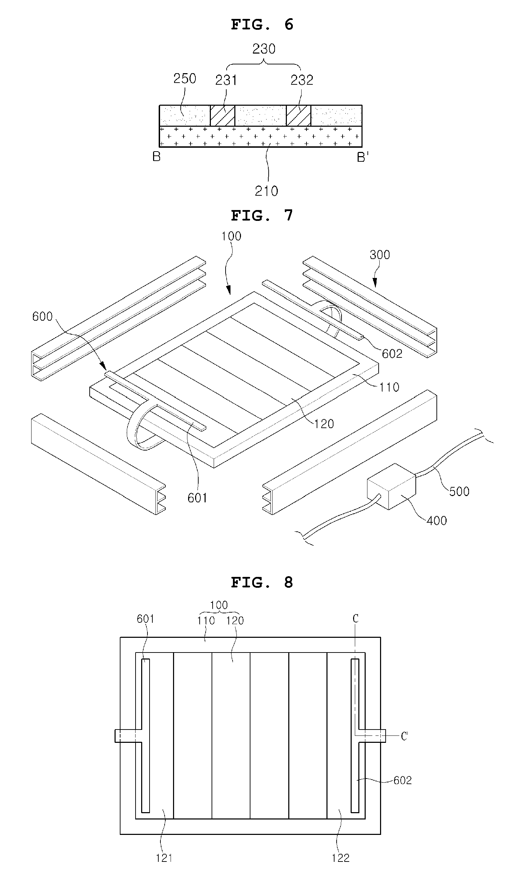

FIG. 1 is an exploded perspective view showing a solar cell module according to a first embodiment. FIG. 2 is a plan view the connection state of a solar cell panel, a bus bar, and a flexible printed circuit board. FIG. 3 is a bottom view showing the connection state of the flexible printed circuit board and the junction box. FIG. 4 is a sectional view taken along line A-A' of FIG. 2. FIG. 5 is a perspective view showing the flexible printed circuit board. FIG. 6 is a sectional view taken along line B-B' of FIG. 5.

Referring to FIGS. 1 to 6, the solar cell module according to the first embodiment includes a solar cell panel 100, a bus bar 130, a flexible circuit bard 200, a frame 300, a junction box 400, and a cable 500.

The solar cell panel 100 has a plate shape. The solar cell panel 100 is provided at the inside of the frame 300. The solar cell panel 100 includes a support substrate 110 and a plurality of solar cells 120.

The support substrate 110 has a plate shape. The support substrate 110 is an insulator. The support substrate 110 may be rigid or flexible. For example, the support substrate 110 may include a soda lime glass substrate. In addition, the support substrate 110 supports the solar cells 120.

The solar cells 120 are provided on the support substrate 110. The solar cells 120 convert the solar light received therein into electrical energy. The solar cells 120 may be connected to each other in series. In addition, the solar cells 120 may be arranged in parallel to each other.

For example, the solar cells 120 may include a CIGS-based solar cell, a silicon-based solar cell, or a dye sensitized solar cell.

Although not shown in the accompanying drawings, the solar cell module according to the embodiment includes protective glass and ethylene vinyl acetate (EVA).

The protective glass is provided on the solar cells 120. The protective glass is provided at the inside of the frame 300 similarly to the solar cell panel 100. The protective glass protects the solar cells 120 from external physical shock and/or foreign matters. The protective glass is transparent. For example, the protective glass may be enhanced glass.

The EVA film is interposed between the protective glass and the solar cells 120. The EVA film performs a buffer function between the protective glass and the solar cells 120.

The bus bar 130 is provided on the solar cell panel 100. The bus bar 130 is provided on the top surface of the solar cells 200. The bus bar 130 is directly connected to the top surface of the outermost solar cells 121 and 122 among the solar cells 120.

The bus bar 130 is a conductor. The bus bar 130 may include copper (Cu), aluminum (Al), tungsten (W), and molybdenum (Mo).

The bus bar 130 extends from the top surface of the solar cell 120 to an outer region without the solar cells 120.

The bus bar 130 includes first and second bus bars 131 and 132. The first bus bar 131 is directly connected to the top surface of one outermost solar cell 121. The second bus bar 132 is directly connected to the top surface of another outermost solar cell 122.

In addition, the first bus bar 131 extends from one outermost solar cell 121. In addition, the second bus bar 132 extends from the other outermost solar cell 122 in a direction opposite to the extension direction of the first bus bar 13.

The flexible printed circuit board 200 is connected to the bus bar 130. The flexible printed circuit board 200 is connected to the solar cells 120 through the bus bar 130. The flexible printed circuit board 200 is provided at the lateral side of the support substrate 110. In detail, the flexible printed circuit board 200 is provided throughout a top surface 111, a lateral side 112, and a bottom surface 113 of the support substrate 110. The flexible printed circuit board 200 extends from the bus bar 130 to the bottom surface 113 of the support substrate 110 through the lateral side 112 of the support substrate 110. In this case, the flexible printed circuit board 200 may extend into the junction box 400.

The flexible printed circuit board 200 is connected to another solar cell module. The flexible printed circuit board 200 may be connected to an adjacent solar cell module through the cable 500. For example, the flexible printed circuit board 200 may be connected to a circuit board provided inside the junction box 400, and may be connected to the adjacent solar cell module through the cable 500 connected to the circuit board.

In this case, the flexible printed circuit board 200 may be directly connected to the junction box 400 or may be connected to the junction box 400 through an additional interconnection.

In addition, the flexible printed circuit board 200 may be directly connected to the adjacent solar cell module. For example, driving elements such as diodes may be directly connected to the flexible printed circuit board 200 to prevent short, and the flexible printed circuit board 200 extends to the adjacent solar cell module so that the flexible printed circuit board 200 can be directly connected to the adj acent solar cell module.

The flexible printed circuit board 200 is flexible. In addition, the flexible printed circuit board 200 adheres to the support substrate 110. In detail, the flexible printed circuit board 200 is bended to adhere to the top surface 111, the lateral side 112, and the bottom surface 113 of the support substrate 110.

The flexible printed circuit board 200 includes an interconnection wire 230, a protective layer 240, and an adhesive layer 250.

The interconnection wire 230 is connected to the bus bar 130. For example, the interconnection wire 230 may include Cu. The interconnection wire 230 may include an electrical circuit. For example, the interconnection wire 230 includes a first interconnection wire 231 connected to the first bus bar 131 and a second interconnection wire 232 connected to the second bus bar 132.

In this case, the first and second interconnection wires 231 and 232 may be directly connected to the first and second bus bars 131 and 132. In addition, the first interconnection wire 231 may be connected to the first bus bar 131 through solder paste. In other words, the solder paste may directly make contact with the first interconnection wire 231 and the first bus bar 131. Similarly, the second interconnection wire 232 maybe connected to the secondbus bar 132 through another solder paste.

The first and second interconnection wires 231 and 232 may have resistivity of 1.72 µΩ**cm**. In addition, the first and second interconnection wires 231 and 232 have widths in the range of about 2mm to about 5mm. The first and second interconnection wires 231 and 232 have thicknesses in the range of about 30**µm** to about 50**µm**. Since the first and second interconnection wires 231 and 232 have low resistance as described above, the first and second interconnection wires 231 and 232 can carry current generated from the solar cells 120.

The protective layer 240 covers the interconnection wire 230 and the adhesive layer 250. The protective layer 240 may support the interconnection wire 230 and the adhesive layer 250. The protective layer 240 is flexible, and includes an insulator. The protective layer 240 insulates interconnection wires 230 from each other. For example, the protective layer 240 may include polyimide.

The adhesive layer 250 is interposed between the protective layer 240 and the support substrate 110. In addition, the adhesive layer 250 is bonded to the support substrate 110. The adhesive layer 250 is bonded to the interconnection wire 230 and/or the protective layer 240. In addition, the flexible printed circuit board 200 is bonded to the support substrate 110 by the adhesive layer 250.

The adhesive layer 250 may include an insulator. The adhesive 250 covers the interconnection wires 230 and insulates the interconnection wires 230 from each other. In addition, the adhesive layer 250 includes an expose region to expose a portion of the interconnection wire 230. The interconnection wire 230 is connected to the bus bar 130 through the expose region.

The frame 300 receives the support substrate 100 and the protective glass. The frame 300 surrounds the support substrate 100 and the protective glass. The frame 300 fixes the support substrate 110 and the protective glass therein.

For example, the frame 300 may include aluminum (Al) or the alloy of Al.

The junction box 400 is provided on the bottom surface 113 of the support substrate 100. The junction box 400 receives a circuit board equipped with the diodes. In the solar cell module according to the embodiment, the junction box 400 may be omitted. In addition, the flexible printed circuit board 200 may be directly connected to an adjacent solar cell module.

The cable 500 extends from the junction box 400. The cable 500 is connected to the flexible printed circuit board 200 through the circuit board received in the junction box 400. In addition, the cable 500 is connected to another solar cell module. In other words, the cable 500 connects the flexible printed circuit board 200 to the adjacent solar cell module.

As described above, the cable 500 may be omitted. In other words, the flexible printed circuit board 200 may be directly connected to another solar cell module without the cable 500.

According to the solar cell module of the embodiment, the electrical energy generated from the solar cells 120 may be output through the flexible printed circuit board 200. In other words, the flexible printed circuit board 200 extends through the lateral side 112 of the support substrate 110.

Therefore, according to the solar cell module of the embodiment, holes used to connect the cable 500 to the bus bar 130 are not formed in the support substrate 110.

In addition, the flexible printed circuit board 200 may be readily attached to the support substrate 110 by the adhesive layer 250. Therefore, the solar cell module according to the embodiment can be readily manufactured.

In addition, diodes may be directly mounted on the flexible printed circuit board 200, and may be directly connected to a solar cell module adjacent to the flexible printed circuit board 200. In other words, in the solar cell module according to the present embodiment, the junction box 400 and the cable 500 may be omitted. Therefore, the solar cell module according to the embodiment may have a simple structure.

Since the flexible printed circuit board 200 is directly connected to the adjacent solar cell module, the solar cell module according to the embodiment can be prevented from being shorted.

In addition, since holes are not formed in the support substrate 110, the solar cell module according to the embodiment can represent more improved strength.

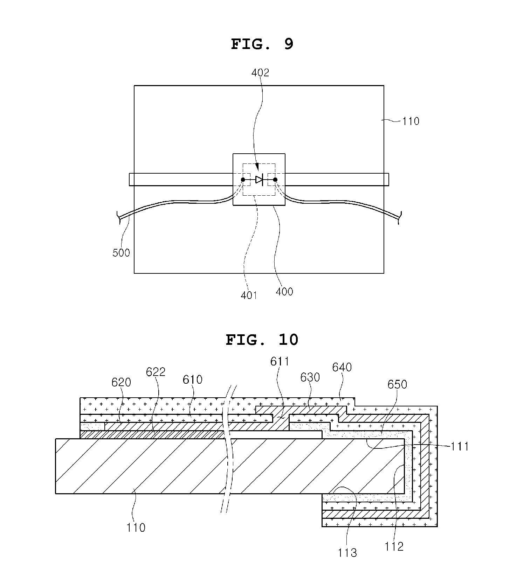

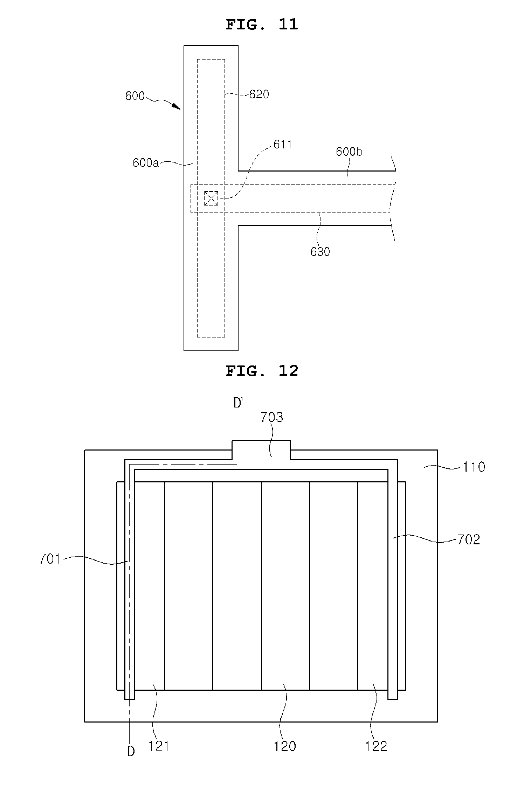

FIG. 7 is an exploded perspective view showing a solar cell module according to a second embodiment. FIG. 8 is a plan view showing the connection state between the flexible printed circuit board and the solar cell panel. FIG. 9 is a bottom view showing the connection state between the flexible printed circuit board and the junction box. FIG. 10 is a sectional view taken along line C-C' of FIG. 8. FIG. 11 is a plan view showing the flexible printed circuit board.

Referring to FIGS. 7 to 11, the solar cell module according to the second embodiment includes the solar cell panel 100, a flexible printed circuit board 600, the frame 300, the junction box 400, and the cable 500.

The solar cell panel 100 has a plate shape. The solar cell panel 100 is provided inside the frame 300. The solar cell panel 100 includes the support substrate 110 and the solar cells 120.

The support substrate 110 has a plate shape. The support substrate 110 is an insulator. The support substrate 110 may be rigid or flexible. For example, the support substrate 110 may include a soda lime glass substrate. In addition, the support substrate 110 supports the solar cells 120.

The solar cells 120 are provided on the support substrate 110. The solar cells 120 convert the solar light received therein into electrical energy. The solar cells 120 may be connected to each other in series. In addition, the solar cells 120 may be arranged in parallel to each other.

For example, the solar cells 120 may include a CIGS-based solar cell, a silicon-based solar cell, or a dye sensitized solar cell.

Although not shown in the accompanying drawings, the solar cell module according to the embodiment includes protective glass and ethylene vinyl acetate (EVA).

The protective glass is provided on the solar cells 120. The protective glass is provided at the inside of the frame 300 similarly to the solar cell panel 100. The protective glass protects the solar cells 120 from external physical shock and/or foreign matters. The protective glass is transparent. For example, the protective glass may be enhanced glass.

The EVA film is interposed between the protective glass and the solar cells 120. The EVA film performs a buffer function between the protective glass and the solar cells 120.

The flexible printed circuit board 600 is connected to the solar cells 120. In more detail, the flexible printed circuit board 600 is directly connected to the solar cells 120.

The flexible printed circuit board 600 is provided on the top surface 111 of the support substrate 110 and the lateral side 112 of the support substrate 110. In detail, the flexible printed circuit board 600 is provided throughout the top surface 111, the lateral side 112, and the bottom surface 113 of the support substrate 110. In other words, the flexible printed circuit board 600 extends from the outermost solar cells 121 and 122 among the solar cells 120 to the bottom surface 113 of the support substrate 110 through the lateral side 12 of the support substrate 110. In this case, the flexible printed circuit board 600 may extend into the junction box 400.

The flexible printed circuit board 600 is connected to another solar cell module. For example, the flexible printed circuit board 600 may be connected to an adjacent solar cell module through the cable 500. In addition, the printed circuit board 600 may be connected to a circuit board provided in the junction box 400, and may be connected to an adjacent solar cell module through the cable 500 connected to the circuit board.

In addition, the flexible printed circuit board 600 may be directly connected to the adjacent solar cell module. For example, driving elements such as diodes may be directly connected to the flexible printed circuit board 600 to prevent short, and the flexible printed circuit board 600 extends to the adjacent solar cell module so that the flexible printed circuit board 600 can be directly connected to the adj acent solar cell module.

The flexible printed circuit board 600 is flexible. In addition, the flexible printed circuit board 600 adheres to the support substrate 110. In detail, the flexible printed circuit board 600 is bended to adhere to the top surface 111, the lateral side 112, and the bottom surface 113 of the support substrate 110.

As shown in FIGS. 10 and 11, the flexible printed circuit board 600 includes an insulating layer 610, a connection wire 620, an interconnection wire 630, a protective layer 640, and an adhesive layer 650.

The insulating layer 610 covers the connection wire 620. The insulating layer 610 may be provided throughout the top surface 111, the lateral side 112, and the bottom surface 113 of the solar cell panel 100. The insulating layer 610 may support the connection wire 620, the interconnection wire 630, and the protective layer 640. The insulating layer 610 may include an insulator. The insulating layer 610 may include polyimide-based resin.

The connection wire 620 is provided under the insulating layer 610. In other words, the connection wire 620 is interposed between the insulating layer 610 and the solar cell panel 100.

The connection wire 620 is connected to the solar cell 120. For example, the connection wire 620 may be connected to the solar cell 120 through the direct contact of the solar cell 120. In detail. The connection wire 620 may be directly connected to the outermost solar cells 121 and 122 among the solar cells 120. The connection wire 620 has a shape to extend in the extension direction of the outermost solar cells 121 and 122.

In addition, the solder paste may be inter posed between the connection wire 620 and the outer solar cells 121 and 122, and the connection wire 620 may be connected to the outermost solar cells 121 and 122 through the solar paste.

The connection wire 630 has a width in the range of about 2mm to about 5mm, and has a thickness in the range of about 30**µm** to about 50**µm**.

The interconnection wire 630 is provided on the insulating layer 610. In other words, the interconnection wire 630 is provided on one surface of the insulating layer 610 facing a surface of the insulating layer 610 on which the connection wire 620 is provided. In other words, the connection and interconnection wires 620 and 630 sandwiches the insulating layer 610 therebetweeen.

The interconnection wire 630 is connected to the connection wire 620. The interconnection wire 630 is connected to the connection wire 620 through a via hole 211 formed in the insulating layer 610.

The interconnection wire 630 transfers electrical energy generated from the solar cells 120 to adjacent solar cell modules. In detail, the interconnection wire 630 may transfer the electrical energy generated from the solar cells 120 to a condenser through the cable 500.

The interconnection wire 630 may have resistivity of about 1.72 µΩ**cm**. In addition, the interconnection wire 630 has a width in the range of about 2mm to about 5mm. The interconnection wire 630 has a thickness in the range of about 30**µm** to about 50**µm**. In addition, since the interconnection wire 630 has low resistance as described above, the current generated from the solar cells 120 can be effectively carried.

The protective layer 640 covers the interconnection wire 630. The protective layer 640 serves as the insulating layer 610, and protects a portion of the interconnection wire 630 from external shock.

The adhesive layer 650 is interposed between the insulating layer 610 and the support substrate 110. In addition, the adhesive layer 650 is bonded to the support substrate 110. In addition, the adhesive layer 650 is bonded to the interconnection wire 630, the connection wire 620, and/or the insulating layer 610. Therefore, the flexible printed circuit board 600 is bonded to the support substrate 110 by the adhesive layer 650.

The adhesive layer 650 may include an insulator. The adhesive layer 650 may cover the connection wire 620 and insulate connection wires 620 from each other.

The flexible printed circuit board 600 may include first and second flexible printed circuit boards 601 and 602. In other words, the first flexible printed circuit board 601 is connected to one outermost solar cell 121, and the second flexible printed circuit board 602 is connected to another outermost solar cell 122.

The first and second flexible printed circuit boards 601 and 602 are symmetrical to each other, and have the same structure.

In addition, the flexible printed circuit board 600 may be divided into a connection part 600a connected to the solar cells 120 and an extension part 600b extending from the connection part 600a to the junction box 400. In this case, the connection wire 620 may be provided in the connection part 600a, and the interconnection wire 630 may be provided in the extension part 600b.

The frame 300 receives the support substrate 110 and the protective glass therein. The frame 300 surrounds the support substrate 110 and the protective glass. The frame 300 fixes the support substrate 110 and the protective glass therein.

The frame 300 may include Al or the alloy thereof.

The junction box 400 is provided on the bottom surface of the support substrate 110. The junction box 400 receives a circuit board equipped with the diodes. In the solar cell module according to the embodiment, the junction box 400 may be omitted.

The cable 500 extends from the junction box 400. The cable 500 is connected to the flexible printed circuit board 600. For example, the cable 500 may be connected to the flexible printed circuit board 600 through a circuit board 401 received in the junction box 400.

In addition, the cable 500 is connected to another solar cell module. In other words, the cable 500 connects the flexible printed circuit board 600 to an adjacent solar cell module.

In addition, the cable 500 may be omitted. In other words, the flexible printed circuit board 600 may be directly connected to another solar cell module without the cable 500.

According to the solar cell module of the present embodiment, the electrical energy generated from the solar cells 120 can be output through the flexible printed circuit board 600. In particular, the flexible printed circuit board 600 extends along the lateral side of the support substrate 110.

Therefore, according to the solar cell module of the present embodiment, a hole, which is used to connect the cable to the bus bar, may not be provided in the support substrate 110.

In addition, the flexible printed circuit board 600 can be readily bonded to the support substrate 110 by the adhesive layer 650. Therefore, the solar cell module according to the present embodiment can be readily manufactured.

In addition, diodes may be directly mounted on the flexible printed circuit board 600, and may be directly connected to a solar cell module adj acent to the flexible printed circuit board 600. In other words, in the solar cell module according to the present embodiment, the junction box 400 and the cable 500 may be omitted. Therefore, the solar cell module according to the embodiment may have a simple structure.

Since the flexible printed circuit board 600 is directly connected to the adjacent solar cell module, the solar cell module according to the present embodiment can be prevented from being shorted.

In addition, since holes are not formed in the support substrate 110, the solar cell module according to the present embodiment can represent more improved strength.

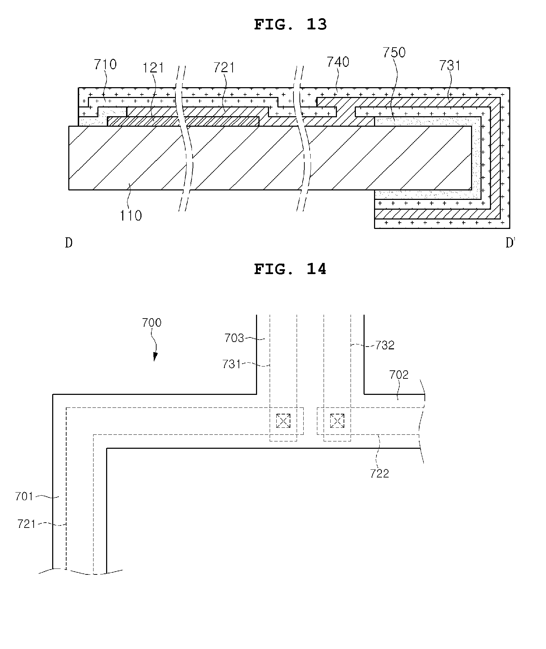

FIG. 12 is a plan view showing the connection between a solar cell panel and a flexible printed circuit board in the solar cell module according to a third embodiment. FIG. 13 is a sectional view taken along line D-D' of FIG. 12. FIG. 14 is a plan view showing the flexible printed circuit board. Hereinafter, the present embodiment will be described by making reference to the description about the previous embodiment, and the flexible printed circuit board will be additionally described. In addition, the description about the previous embodiment will be incorporated in the description about the present embodiment except for modifications.

Referring to FIG. 12, differently from the previous embodiment, a flexible printed circuit board 700 has the form of a single body without being classifying the first and second flexible printed circuit boards 601 and 602.

The flexible printed circuit board 700 includes a first connection part 701, a second connection part 702, and an extension part 703.

The first connection part 701 is connected to one outermost solar cell 121. The first connection part 701 is connected to the extension part 703.

The first connection part 701 includes a first connection wire 721. The first connection wire 721 is directly or indirectly connected to one outermost solar cell 121. For example, the first connection wire 721 is connected to the outermost solar cell 121 through the direction contact with the outermost solar cell or through solder paste.

The second connection part 702 is connected to another outermost solar cell 122. The second connection part 702 is connected to the extension part 703.

The second connection part 702 includes a second connection wire 722. The second connection wire 722 is directly or indirectly connected to the outermost solar cell 122.

The extension part 703 is connected to the first and second connection parts 701 and 702, and connected to an adj acent solar cell module or a condenser through a direct scheme or through the cable 500.

The extension part 703 includes a first interconnection wire 731 connected to the first connection wire 721 and a second interconnection wire 732 connected to the second connection wire 722.

The extension part 703 is provided through the bottom surface and the lateral side of the solar cell panel 100. The extension part 703 may extend to the junction box 400. The extension part 703, the first connection part 701, and the second connection part 702 may be integrally formed with each other.

The extension part 703 may include a driving device, such as a diode, to drive the solar cell panel 100.

In addition, the flexible printed circuit board 700 includes an insulating layer 710, a protective layer 740, and an adhesive layer 750.

According to the solar cell module of the present embodiment, the extension part 703 may include the driving device. Therefore, the solar cell module according to the present embodiment may be connected to an adjacent solar cell module or a condenser without being used the junction box 400.

Therefore, the solar cell module according to the present embodiment can have a simpler structure, and can be readily manufactured.

Any reference in this specification to "one embodiment," "an embodiment," "example embodiments," etc., means that a particular feature, structure, or characteristic described in connection with the embodiment is included in at least one embodiment of the invention. The appearances of such phrases in various places in the specification are not necessarily all referring to the same embodiment. Further, when a particular feature, structure, or characteristic is described in connection with any embodiment, it is submitted that it is within the purview of one skilled in the art to effect such feature, structure, or characteristic in connection with other ones of the embodiments.

Although embodiments have been described with reference to a number of illustrative embodiments thereof, it should be understood that numerous other modifications and embodiments can be devised by those skilled in the art that will fall within the spirit and scope of the principles of this disclosure. More particularly, various variations and modifications are possible in the component parts and/or arrangements of the subject combination arrangement within the scope of the disclosure, the drawings and the appended claims. In addition to variations and modifications in the component parts and/or arrangements, alternative uses will also be apparent to those skilled in the art.

### [Industrial Applicability]

The embodiments are applicable to the solar power generation field.

## Claims

1. A solar cell apparatus comprising:
a support substrate;
a solar cell on a top surface of the support substrate; and
a circuit board connected to the solar cell and provided on both the top surface of the support substrate and a lateral side of the support substrate.

2. The solar cell apparatus of claim 1, further comprising a bus bar directly making contact with a top surface of the solar cell and connected to the circuit board.

3. The solar cell apparatus of claim 2, wherein the circuit board comprises:
an interconnection wire connected with the bus bar;
an adhesive layer bonded to the support substrate; and
a protective layer to cover the interconnection wire and the adhesive layer.

4. The solar cell apparatus of claim 3, wherein the interconnection wire has a thickness in a range of about 30*µ*m to about 50*µ*m, and has a width in a range of about 2mm to about 5mm.

5. The solar cell apparatus of claim 3, further comprising a solder paste directly making contact with the bus bar and the interconnection wire.

6. The solar cell apparatus of claim 1, wherein the circuit board is flexible.

7. The solar cell apparatus of claim 1, further comprising a junction box on a bottom surface of the support substrate, wherein the circuit board extends into the junction box.

8. The solar cell apparatus of claim 1, wherein the circuit board is directly connected with the solar cell.

9. The solar cell apparatus of claim 1, wherein the circuit board comprises:
a connection wire directly connected to the solar cell;
an insulating layer covering the connection wire; and
an adhesive layer bonded to the support substrate.

10. The solar cell apparatus of claim 9, wherein the circuit board comprises a interconnection wire which interposes the insulating layer between the connection wire and the interconnection wire, and is connected with the connection wire through a via hole formed in the insulating layer.

11. The solar cell apparatus of claim 9, wherein the connection wire has a thickness in a range of about 30*µ*m to about 50*µ*m, and has a width in a range of about 2mm to about 5mm.

12. The solar cell apparatus of claim 1, further comprising a diode installed in the circuit board.

13. A solar cell apparatus comprising:
a support substrate;
a first solar cell on the support substrate;
a second solar cell spaced apart from the first solar cell;
a plurality of third solar cells between the first and second solar cells;
a first circuit board connected to the first solar cell and extending on a first lateral side of the support substrate; and
a second circuit board connected to the second solar cell and extending on a second lateral side of the support substrate.

14. The solar cell apparatus of claim 13, wherein the first and second lateral sides face each other.

15. The solar cell apparatus of claim 13, wherein the first circuit board includes a connection wire extending in a direction a same as an extension direction of the first solar cell, and the connection wire directly makes contact with the first solar cell.

16. The solar cell apparatus of claim 15, wherein the first circuit board comprises:
an interconnection wire connected to the connection wire; and
an insulating layer between the connection wire and the interconnection wire, and
wherein the interconnection wire extends to a bottom surface of the support substrate through the first lateral side.

17. A solar cell apparatus comprising:
a support substrate;
a first solar cell on the support substrate;
a second solar cell on the support substrate; and
a circuit board connected to the first and second solar cells,
wherein the circuit board comprises:
a first connection part connected to a top surface of the first solar cell;
a second connection part connected to a top surface of the second solar cell; and
an extension part formed integrally with the first and second connection parts and extending along a lateral side of the support substrate.

18. The solar cell apparatus of claim 17, wherein the first connection part comprises a first connection wire making contact with the first solar cell,
the second connection part comprises a second connection wire making contact with the second solar cell, and
the extension part comprises a first interconnection wire connected to the first connection wire and a second interconnection wire connected to the second connection wire.
